# FASCICULE DE BREVET EUROPEEN

(11) **EP 3 063 698 B1**
(45) Date de publication et mention de la délivrance du brevet: **19.08.2020**
(21) Numéro de dépôt: 14789818.3
(22) Date de dépôt: 24.10.2014
(51) Int. Cl.: G06K 7/00

(54) **PROCÉDÉ DE FABRICATION D'UN CORPS DE LECTEUR DE CARTE À MÉMOIRE, CORPS DE LECTEUR DE CARTE À MÉMOIRE ET TERMINAL DE LECTURE DE CARTE À MÉMOIRE CORRESPONDANTE**
VERFAHREN ZUR HERSTELLUNG EINES SPEICHERKARTENLESERKÖRPERS, SPEICHERKARTENLESERKÖRPER UND ENTSPRECHENDES SPEICHERKARTENLESER-TERMINAL
MANUFACTURING PROCESS OF A MEMORY CARD READER HOUSING, MEMORY CARD READER HOUSING AND READER TERMINAL OF A CORRESPONDING MEMORY CARD

(30) Priorité: 31.10.2013 FR 1360708
(43) Date de publication de la demande: 07.09.2016
(73) Titulaire: Ingenico Group, 75015 Paris (FR)
(72) Inventeur: JADEAU, Johann, 26500 Bourg-les-Valence (FR); PAVAGEAU, Stéphane, 26600 La Roche De Glun (FR)
(74) Mandataire: Vidon Brevets & Stratégie
(86) Numéro de dépôt international: PCT/EP2014/072824
(87) Numéro de publication internationale: WO 2015/062982

(56) Documents cités:
- FR-A1- 2 906 623
- US-A1- 2009 302 109

## Description

### 1. Domaine de l'invention

L'invention se situe dans le domaine des lecteurs de cartes à mémoire. L'invention a plus particulièrement comme objet un lecteur de cartes à mémoire comprenant un connecteur de cartes à mémoire (CAM) destiné à être inséré dans un terminal de lecture de cartes à mémoire.

Un tel terminal peut être un terminal de paiement, un terminal d'identification. Plus généralement, l'invention se rapporte à tout type de terminal pouvant comprendre un lecteur de cartes à mémoire.

### 2. Art Antérieur

Les terminaux de lecture de cartes à mémoire comprennent, outre un lecteur de cartes à mémoire, un certain nombre de composants tels qu'un clavier, un écran, un ou plusieurs processeurs, une mémoire, une source d'alimentation électrique.

Depuis plusieurs années, les terminaux de lecture de cartes à mémoire ont vu leurs fonctions multipliées. Ceci est particulièrement vrai pour les terminaux de paiement.

Ainsi, outre la fonction de paiement, les terminaux embarquent des fonctions de communication en réseau, des fonctions de détection de cartes à mémoire sans contact (de l'anglais « *contactless* »), des fonctions de gestion de coupons (par exemple des coupons de fidélité), etc.

En plus de la multiplication de telles fonctions auxiliaires, les terminaux de lecture de cartes à mémoire doivent être résistants aux diverses attaques ou tentatives de fraudes dont ils sont fréquemment l'objet. Afin d'obtenir une homogénéité de la résistance des terminaux aux attaques, des normes internationales ont été édictées. Dans le domaine du paiement, par exemple, la norme PCI PED (de l'anglais « *Payment Card Industry* - *Pin Entry Device* ») édicte des exigences en matière d'intrusion et de détection des tentatives d'attaques sur les terminaux. Il ne s'agit pas de la seule norme en vigueur.

Cependant, du fait de ces normes, les terminaux, qui étaient antérieurement peu protégés, laissent progressivement la place à des terminaux de plus en plus sécurisés. Parmi les points de sécurisation des terminaux, les industriels du secteur veillent plus particulièrement à la protection du lecteur de cartes à mémoire. Le lecteur de cartes à mémoire, en effet, reste un maillon relativement faible du terminal de lecture de carte à mémoire. Ceci est dû au fait que le lecteur de cartes à mémoire comprend une fente d'insertion de la carte à mémoire, cette fente rendant l'intérieur du terminal accessible depuis l'extérieur.

Plus particulièrement, des attaquants cherchent à se procurer un accès au connecteur de carte à mémoire.

Le connecteur de carte à mémoire est la partie du lecteur de carte à mémoire qui entre en contact avec la puce ou le microprocesseur embarqué sur la carte à mémoire.

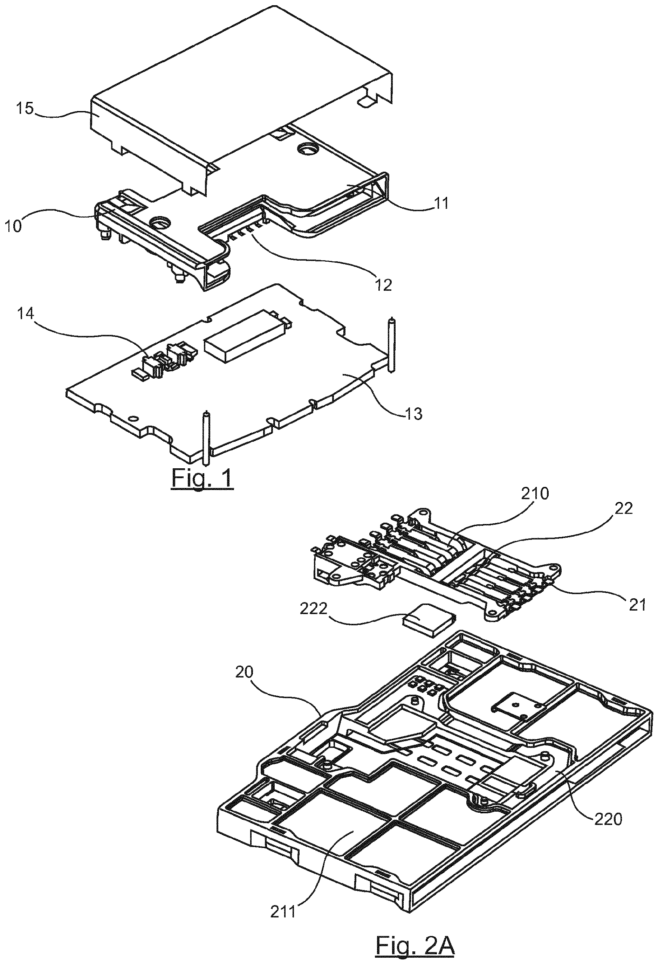

On décrit, en relation avec la figure 1, un assemblage classique d'un lecteur de cartes à mémoire. Ce lecteur de cartes à mémoire comprend un corps de lecteur de cartes à mémoire 10, comprenant une fente 11 d'insertion d'une carte à mémoire. Le connecteur de carte à mémoire est directement intégré au sein du lecteur de cartes à mémoire. Il comprend des broches de connexion 12 au circuit imprimé (PCB pour « *Printed Circuit Board* » en anglais) 13 (vue partielle). Le PCB 13 comprend également des composants électroniques 14. Pour protéger le lecteur de cartes à mémoire 10, celui-ci est recouvert d'une protection complète 15, ainsi que d'une protection frontale.

Lorsqu'un attaquant parvient à avoir accès au connecteur de carte à mémoire, sans que quiconque s'en aperçoive, il est alors possible d'intercepter et de lire les données qui sont échangées entre la puce ou le microprocesseur de la carte à mémoire et le processeur du terminal de lecture de carte à mémoire. Parmi les données interceptées, on peut notamment citer le code secret saisi par le client lors de la demande de code secret, qui peut être véhiculé sans cryptage, sur certaines cartes à puce.

Ceci explique que de nombreux efforts ont été portés à la sécurisation du lecteur de cartes à mémoire. Ainsi, par exemple, les lecteurs de cartes à mémoire ont été pourvus d'une protection avec treillis. Cette protection permet d'éviter une introduction par perçage du terminal. Lorsqu'un objet tente de pénétrer dans l'enceinte de protection, un court-circuit est produit entraînant alors une mise hors service du terminal.

Ces efforts de protection ont entrainé une complexité de fabrication importante, et le coût de fabrication a également augmenté. Actuellement, les exigences normatives en matière de sécurité sont telles qu'il est nécessaire de prévoir, pour la fabrication d'un terminal de lecture, de nombreuses étapes qui mêlent à la fois les soudures échelonnées de composants, la nécessité de disposer de composants résistants à la refusion, etc. Outre la complexité de fabrication du terminal de lecteur de cartes à mémoire, ces procédés rendent la maintenance des terminaux produits très complexe voire impossible, suscitant ainsi bien des difficultés pour les prestataires de services de maintenance autant que pour le fabricant du terminal de lecture de carte à mémoire.

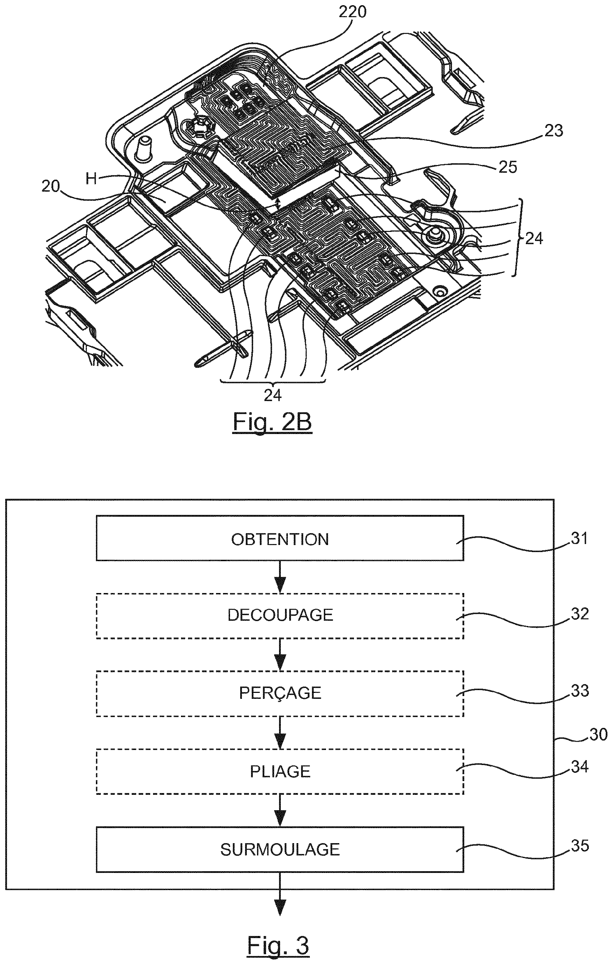

Afin de pallier la complexité de fabrication de l'art antérieur, un autre assemblage est proposé et illustré par les figures 2A et 2B, la figure 2B illustrant en particulier le fait que le logement de réception 220 du connecteur de carte à mémoire comprend au moins une piste conductrice 23.

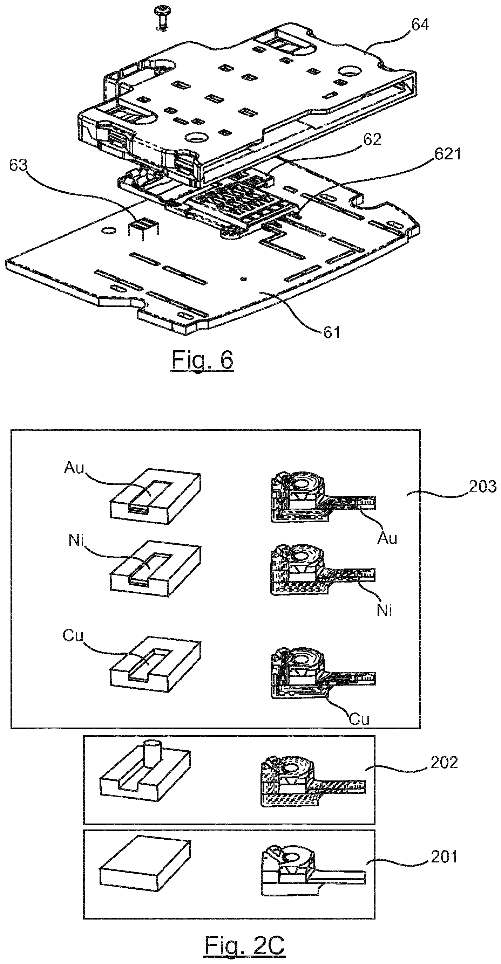

Au regard de la configuration d'assemblage classique illustré par la figure 1, cette solution représentée par la figure 2 facilite le montage, le connecteur de carte à mémoire 10 étant indépendant du corps du lecteur de cartes à mémoire 20.

Ainsi, selon cette proposition, le connecteur de carte à mémoire 22 n'est pas assemblé avec le corps du lecteur de cartes à mémoire 20 avant d'être assemblé au circuit imprimé (PCB) du terminal de lecture. La technique décrite propose de fixer le connecteur de carte à mémoire 22 en premier sur le PCB, puis ensuite de fixer le corps du lecteur de cartes à mémoire 20 par-dessus le connecteur 22. En d'autres termes, on comprend que cet assemblage n'est pas du tout de même nature que l'assemblage de la figure 1 puisque le connecteur de carte à mémoire est recouvert par le corps du lecteur de cartes à mémoire qui vient en quelque sorte le protéger.

Selon un mode de réalisation de cette configuration d'assemblage, dans le corps du lecteur de cartes à mémoire 20, le logement de réception 220 du connecteur de carte à mémoire, comprenant au moins une piste conductrice, est une pièce moulée par injection thermoplastique dans laquelle les pistes de circuit électronique sont intégrées en trois dimensions lors de l'injection, un tel logement de réception est appelé par la suite logement de réception MID ou pièce MID (de l'anglais « *Molded Interconnect Device* »). Les pistes conductrices tridimensionnelles du logement de réception MID 220 jouent donc le rôle de treillis de protection du connecteur de carte à mémoire, en particulier du signal d'entrée sortie I/O (de l'anglais « Input/Output ») transitant entre la carte à mémoire (carte à puce) et le connecteur de carte à mémoire, et de protection des composants localisés à proximité du parcours du signal I/O, et localisés à proximité d'un microprocesseur.

Plus particulièrement, selon cette configuration, le logement de réception MID 220 du connecteur de carte à mémoire, localisé dans le corps du lecteur de carte à mémoire 20, permet de protéger deux surfaces en parties opposées. En effet, une gravure au laser est réalisée afin de produire les pistes électroniques 23 en trois dimensions.

Pour intégrer de telles pistes conductrices au sein de la pièce une technique de gravure au laser est par exemple utilisée.

Plus précisément, parmi les techniques de gravure au laser connues, la technique consistant à utiliser un matériau thermoplastique dopé avec un additif métal-plastique activé au moyen d'un laser est utilisée et connue sous le nom de LDS (de l'anglais « *Laser Direct Structuring »).*

Outre le fait que la technique de fabrication de pièces MID est relativement coûteuse à mettre en œuvre, l'inconvénient d'une telle pièce MID, utilisée pour loger le connecteur de carte à mémoire dans le corps de lecteur de carte à mémoire, réside dans sa faible tenue au regard des conditions climatiques, tel que le froid ou l'humidité et également sa faible résistance au regard des frottements relatifs à l'insertion/retrait de cartes à mémoire.

Pour pallier cet inconvénient, le dépôt d'un vernis de protection, ou un espacement entre le MID et la localisation du passage de carte, appelé « épaisseur impactée », sont par exemple mis en œuvre, mais ces solutions augmentent en conséquence le coût et le temps de fabrication.

En outre, des trous sont prévus dans le circuit imprimé gravé au laser afin d'insérer des « plots d'élévation » 24 établissant une distance entre la ou les pistes du logement de réception MID et la carte à mémoire qui sera insérée/retirée.

En outre, il est à noter, qu'un tiers malintentionné pourrait percer le corps de lecteur de carte à mémoire à l'endroit même de ces plots d'élévation pour atteindre et détériorer le connecteur de carte à mémoire ou la carte à mémoire elle-même. Il est donc nécessaire que la position de ces trous au sein du circuit du treillis de protection ne correspond pas à la position de composants et/ou du trajet de signaux à protéger.

La prévision de ces trous et leur localisation dans le treillis de protection rend donc plus complexe sa conception.

Par ailleurs, les changements de niveau de gravure du MID, peuvent également entrainer des zones sans pistes sur une hauteur H tel que représenté sur la figure 2B. En conséquence, le circuit imprimé du treillis de protection du logement de réception MID 220 est complexe, les pistes conductrices 23 étant détournées pour éviter un décroché, encore appelé « marche », formé par le changement de niveau 25 de hauteur H.

La demande de brevet américain US 2009/302109 propose la mise en œuvre d'une grille de protection pour entourer au moins une zone du boîtier d'un lecteur de carte sujette à des manipulations indésirables. La demande de brevet français FR 2906623 divulgue un dispositif anti-intrusion comprenant un treillis relié à des moyens de traitement d'une carte électronique. Cependant, les solutions proposées dans les deux demandes de brevet sont relativement complexes et assez coûteuses à réaliser.

Il existe donc un besoin de fournir une nouvelle technique de fabrication d'un corps de lecteur à carte mémoire de logement de réception de connecteurs de carte à mémoire dépourvue de restrictions techniques et dont la complexité et les coûts de mise en œuvre sont limités, afin de fournir des logements de connecteurs de carte à mémoire résistants à toutes conditions climatiques, notamment l'humidité, et aux frottements dus l'insertion/retrait de cartes à mémoire.

### 3. Résumé de l'invention

Selon la présente invention, il est proposé un procédé de fabrication d'un corps de lecteur de carte à mémoire et un corps de lecteur de carte à mémoire correspondant selon les revendications 1 et 8. Des modes de réalisation préférés sont définis dans les revendications dépendantes 2-7 et 9, 10.

La technique décrite propose une solution nouvelle qui ne présente pas au moins certains des inconvénients de l'art antérieur, sous la forme d'un procédé de fabrication d'un corps de lecteur de carte à mémoire de forme globalement parallélépipédique rectangle comprenant une fente d'insertion d'une carte à mémoire, dont une face postérieure comprend un logement de réception d'un connecteur de carte à mémoire, ledit logement de réception étant d'une forme volumique prédéterminée.

Selon la technique décrite, ledit procédé de fabrication comprend les étapes successives suivantes:
- obtention d'un circuit imprimé flexible comprenant au moins deux zones :
   - une zone comprenant ladite au moins une piste conductrice formant un treillis de protection apte à détecter une intrusion, et
   - au moins une zone de contact,
- formation dudit logement de réception par surmoulage dudit circuit imprimé flexible.

Ainsi, la technique décrite propose d'utiliser un circuit imprimé flexible en tant que treillis de protection du logement de réception d'un connecteur de carte à mémoire. Le circuit imprimé flexible selon la technique décrite est ensuite protégé et rendu immobile au sein du corps de lecteur de carte à mémoire par surmoulage.

Le surmoulage permet de rendre invisible au moins une partie du treillis de protection formé par la ou les piste(s) conductrice(s) du circuit imprimé flexible et de le protéger en conséquence contre des conditions climatiques défavorables telles que l'humidité, le froid ou encore des frottements relatifs à l'insertion/retrait de cartes à mémoire.

En effet, le surmoulage du circuit imprimé flexible permet de protéger efficacement le treillis de protection du circuit imprimé flexible du fait que la couche de surmoulage épouse fidèlement l'ensemble du circuit imprimé flexible et assure la même fonction que le vernis de protection ajouté sur une pièce MID selon l'art antérieur, tout en renforçant son efficacité contre l'abrasion, puisque l'épaisseur du surmoulage peut être de quelques dixièmes de mm (0,5 à 1mm,), contre quelques microns (10 à 50µm) pour le vernis, qui présente de ce fait une épaisseur 20 à 50 fois moins importante.

Ainsi, la technique décrite permet de limiter le nombre d'opérations nécessaires pour insérer et protéger un treillis de protection dans le logement de réception d'un connecteur de carte à mémoire.

En effet, au regard de la technique MID de l'art antérieur qui requiert au moins trois étapes majeures de fabrication illustrées par la figure 2C à savoir l'injection 201 de la matière plastique dans un matériau spécifique activable, la gravure laser 202 permettant à la métallisation de s'accrocher, la métallisation 203 coûteuse et complexe de pistes, par bains successifs de métaux distincts (cuivre Cu, nickel Ni, or Au..) d'une partie du corps de lecteur de carte à mémoire, et enfin la protection par un vernis, la technique décrite permet la fabrication d'un corps de lecteur de carte à mémoire performant et résistant par surmoulage d'un circuit imprimé flexible.

Ainsi, la technique décrite diffère de la technique MID selon l'art antérieur, en ce qu'au lieu de chercher à insérer un treillis de protection sur un logement de réception déjà existant, le logement de réception selon la présente technique est fabriqué en surmoulant un treillis de protection d'un circuit imprimé flexible existant, le surmoulage permettant en outre de recouvrir et donc de protéger le treillis de protection.

La technique décrite permet donc de s'affranchir de toute contrainte de gravure liée au relief du logement de réception d'un connecteur de carte à mémoire, alors que selon l'art antérieur relatif à la technique MID, il était nécessaire de détourner des pistes conductrices en cas de décroché, également appelé « marche », du logement de réception de connecteur de carte à mémoire telle que celle de hauteur H représentée sur la figure 2B.

Au contraire, selon la technique ici proposée, les pistes conductrices du treillis de protection sont disposées sur le circuit imprimé flexible dont la forme ou relief sera fixée lors de l'étape de surmoulage. Ainsi, au regard de la technique MID, où l'on grave un circuit imprimé dans un logement de réception existant dont le relief est fixe et requiert d'adapter le circuit imprimé en détournant des pistes, la technique ici décrite est simple et peu complexe à mettre en œuvre, et aisément industrialisable, car la forme du circuit imprimé flexible est adaptée avec l'étape de surmoulage formant le logement de réception du connecteur de carte à mémoire selon l'invention.

La technique décrite permet ainsi d'économiser le coût d'implémentation de la technique MID de l'art antérieur tout en étant simple à implémenter et résistante dans le temps au regard de conditions climatiques, de frottement ou d'autres sources d'usure ou de vandalisme du corps de lecteur de carte à mémoire.

Selon un aspect particulier de la technique décrite, le procédé de fabrication comprend une étape de découpage du circuit imprimé flexible.

Cette étape de découpage permet notamment d'adapter la forme ou le volume du corps de lecteur de carte à mémoire fabriqué selon l'invention, cette forme pouvant varier d'un modèle de lecteur de carte à mémoire à l'autre.

En effet, un modèle de lecteur de carte à mémoire particulier « impose » une forme du logement de réception constituant le corps de lecteur de carte à mémoire. Du fait que selon la technique ici proposée, le logement de réception constituant le corps de lecteur de carte à mémoire est obtenu par surmoulage du circuit imprimé flexible, la forme du logement de réception souhaitée « impose » également une « pré-formation » du circuit imprimé flexible obtenue selon ce mode de réalisation par découpage.

Ainsi, cette étape de découpage offre une grande flexibilité de fabrication.

En outre, une telle étape de découpage peut permettre de sérialiser la fabrication d'un corps de lecteur de carte à mémoire selon la technique présentée. En effet, il peut être utile de produire un « grand » circuit imprimé flexible dont la découpe fournira plusieurs circuits imprimés flexibles destinés à la fabrication par surmoulage d'autant de corps de lecteurs de carte à mémoire.

Selon un aspect particulier de la technique décrite, ladite étape de formation dudit logement de réception par surmoulage dudit circuit imprimé flexible comprend une étape de solidarisation d'une plaque rigide sous ledit circuit imprimé flexible, ladite étape de solidarisation étant mise en œuvre préalablement audit surmoulage.

Une telle plaque est par exemple une plaque métallique permettant d'éviter des déformations indésirables lors du surmoulage.

Selon un aspect particulier de la technique décrite, le procédé de fabrication comprend une étape de perçage d'au moins une ouverture de positionnement dans le circuit imprimé flexible, l'ouverture de positionnement étant prise en compte pour l'étape de formation du logement de réception par surmoulage du circuit imprimé flexible et/ou une étape de pliage (34) dudit circuit imprimé flexible.

L'étape de perçage permet d'améliorer la précision de la localisation du circuit imprimé flexible dans le moule utilisé pour le surmoulage.

Ce mode de réalisation de la technique proposée augmente la précision du surmoulage, mais surtout la précision de localisation des pistes requise pour assurer une bonne connexion, la zone de contact, également appelée zone de connexion, du circuit imprimé flexible portant le treillis de protection devant être positionnée en face de la zone de connexion du circuit dédié aux composants électroniques assurant le fonctionnement électronique du lecteur de carte à mémoire tel que le connecteur de carte à mémoire sur lequel le corps de lecteur est adapté.

Par exemple, une ouverture de positionnement est disposée dans la zone de connexion et une autre ouverture de positionnement est localisée dans la zone comprenant la ou les piste(s) conductrice(s) formant le treillis de protection.

L'ouverture de positionnement localisée dans la zone de connexion est primordiale au regard de l'ouverture de positionnement localisée dans la zone comprenant la ou les piste(s) conductrice(s) formant le treillis de protection, car elle permet de fiabiliser la sécurisation circuit dédié aux composants électroniques assurant le fonctionnement électronique du lecteur de carte à mémoire.

Il est à noter que cette ouverture de positionnement, contrairement aux ouvertures mises en œuvre selon la technique MID pour insérer des « plots d'élévation » afin d'établir une distance entre la ou les pistes du logement de réception MID et la carte à mémoire de sorte à éviter un frottement de la carte mémoire contre les pistes du treillis de protection du logement de réception, est localisée à une position sélectionnée de sorte qu'aucune intrusion ultérieure, notamment frauduleuse, n'est possible ou efficace par cette ouverture.

L'étape de pliage permet également une « préformation » du circuit imprimé flexible afin d'obtenir plus facilement la forme souhaitée du logement de réception constituant le corps de lecteur de carte à mémoire à l'issue de l'étape de surmoulage et peut être combinée ou non à une étape de découpage du circuit imprimé flexible telle que décrite précédemment

L'étape de pliage du circuit imprimé flexible est donc réalisée avant l'étape de surmoulage et permet d'améliorer la qualité du surmoulage et de ménager la résistance des pistes de cuivre lors de l'injection. En effet, le pliage permet de définir des languettes ou des décrochés dans le circuit imprimé flexible afin que celui-ci adhère mieux au moule du surmoulage et que la position du circuit imprimé flexible lors de l'injection sous pression soit maitrisée. Par exemple un pli « vertical » permet d'empêcher un accès latéral et un pli « horizontal » permet de protéger la carte.

Un tel pliage permet donc de former des changements de niveaux correspondant aux changements de niveaux du modèle de corps de lecteur de carte à mémoire que l'on souhaite obtenir. Après l'étape de pliage, on peut vérifier la couverture globale du relief ainsi obtenu par le treillis de protection du circuit imprimé flexible.

En effet, selon la technique ici proposée, il n'est plus nécessaire de dévier les pistes conductrices pour éviter les changements de niveau, tel que pratiqué selon la technique MID de l'art antérieur. Ainsi, selon la technique ici proposée la couverture du treillis de protection est globale, en d'autres termes les décrochés (ou « marches ») du relief du logement de réception sont couvertes par une ou des pistes conductrices et l'étape de pliage permet en outre de vérifier qu'aucune piste conductrice n'est altérée par le pliage et la mise en forme ultérieure et définitive qui aura lieu par application de l'étape de surmoulage.

Selon un aspect particulier de ce mode de réalisation ladite au moins une ouverture de positionnement est localisée à proximité d'au moins un bord dudit circuit imprimé flexible et à une distance minimale de 10 mm de ladite au moins une piste conductrice.

Ainsi, l'ouverture de positionnement selon l'invention est placée suffisamment loin du treillis de protection de sorte que le treillis de protection offre une couverture globale sous la surface du logement de réception destinée à recevoir le connecteur de carte à mémoire.

Ainsi, cet aspect de la technique ici proposée se distingue clairement de la technique MID où le treillis de protection est percé pour insérer des « plots d'élévation » afin d'établir une distance entre la ou les pistes du logement de réception MID et la carte à mémoire. Selon la technique MID la distance entre un trou localisé au cœur du treillis protection et une piste conductrice du treillis de protection est de 2,5mm. Ainsi, la technique MID requiert le détournement des pistes conductrices autour de l'ouverture. Au contraire, selon la présente technique, les trous de positionnement sont situés en dehors du treillis II est donc impossible d'y introduire quoique ce soit une fois le surmoulage effectué et quand bien même, ces ouvertures sont suffisamment éloignées du treillis de protection pour ne pas modifier la détection d'intrusion visée par son implémentation.

De plus, la technique MID, de part se structure, est une technologie mono face. Le circuit imprimé flexible selon la technique ici décrite, offre plus de possibilités, à savoir la mise en œuvre d'un circuit biface avec un plan de masse permettant d'éviter le perçage sans mettre pour autant la masse et le treillis en court-circuit, ou même encore un circuit multicouche comprenant plusieurs couches de treillis superposées.

Selon un aspect particulier de la présente technique, ledit surmoulage est tel que :
- ladite zone comprenant ladite au moins une piste conductrice est recouverte par un matériau de surmoulage sur ses deux faces,
- ladite zone de contact est recouverte par un matériau de surmoulage sur une seule face.

Ainsi le surmoulage, permet de protéger complètement le treillis de protection hormis la zone de contact qui sera par la suite recouverte par et connectée au connecteur de carte à mémoire.

Il est à noter qu'une telle zone de contact comprend par exemple les broches de connexion du treillis de protection qui seront connectées au circuit dédié aux composants électroniques assurant le fonctionnement électronique du dispositif électronique par l'intermédiaire d'un connecteur élastomère, par exemple de type Zebra (Marque déposée).

Selon un autre aspect particulier de la technique décrite, le matériau de surmoulage est un matériau conducteur ou dissipatif.

Cette caractéristique du matériau de surmoulage permet par exemple de dissiper les charges électrostatiques lors de l'introduction de la carte à mémoire dans le corps de lecteur de carte à mémoire.

Par exemple, ce matériau de surmoulage est un polycarbonate conducteur.

Selon un autre aspect, la technique décrite se rapporte également à un corps de lecteur de carte à mémoire de forme globalement parallélépipédique rectangle comprenant une fente d'insertion d'une carte à mémoire, dont une face postérieure comprend un logement de réception d'un connecteur de carte à mémoire, ledit logement de réception étant d'une forme volumique prédéterminée,

Selon la technique décrite, ledit logement de réception est un surmoulage d'un circuit imprimé flexible comprenant au moins deux zones :
- une zone comprenant ladite au moins une piste conductrice formant un treillis de protection apte à détecter une intrusion, et
- au moins une zone de contact.

Les avantages de ce corps de lecteur sont les mêmes que ceux présentés en relation avec le procédé de fabrication selon la technique décrite et vise à proposer un corps de lecteur de carte à mémoire obtenu par surmoulage d'un circuit imprimé flexible comprenant au moins une piste conductrice formant un treillis de protection. Ces avantages ne sont donc pas détaillés plus amplement. En particulier, un tel corps de lecteur de carte à mémoire est fiable du fait que le treillis de protection qu'il contient est protégé par le matériau de surmoulage.

Selon une variante, un tel corps de lecteur de carte à mémoire comprend au moins une ouverture de positionnement dans ledit circuit imprimé flexible. Ainsi, si le corps de lecteur de carte à mémoire est désassemblé, la technique présentée sera facilement identifiable du fait de la présence de l'ouverture dans le circuit imprimé flexible du corps de lecteur de carte à mémoire.

En outre, selon une autre variante, un tel corps de lecteur comprend une plaque rigide solidarisée sous ledit circuit imprimé flexible, préalablement à la mise en œuvre du surmoulage

Ainsi, la superposition du circuit imprimé flexible et de la plaque rigide sera surmoulée de manière fiable en évitant des déformations potentielles du circuit imprimé flexible liées à la pression d'injection lors du surmoulage.

Selon un autre aspect, la technique décrite se rapporte également à un terminal de lecture de carte à mémoire comprenant un corps de lecteur de carte tel que décrit ci-dessus.

### 4. Figures

D'autres caractéristiques et avantages de la technique décrite apparaîtront plus clairement à la lecture de la description suivante d'un mode de réalisation préférentiel, donné à titre de simple exemple illustratif et non limitatif, et des dessins annexés, parmi lesquels :
- la figure 1, déjà présentée, expose l'architecture classique d'un lecteur de cartes à mémoire,
- les figures 2A à 2C, déjà présentées, exposent respectivement l'architecture d'un autre lecteur de cartes à mémoire, une pièce MID le constituant selon l'art antérieur relatif à cette configuration d'assemblage et les étapes mises en œuvre selon la technique MID.
- la figure 3 illustre le procédé de fabrication selon la technique décrite ;
- les figures 4A à 4H illustrent les différentes étapes du procédé de fabrication selon la technique décrite,
- les figures 5A à 5C illustrent différentes parties du corps de lecteur de carte à mémoire selon la technique décrite.
- la figure 6 illustre l'assemblage d'un terminal de lecture de carte à mémoire comprenant un corps de lecteur fabriqué selon la technique décrite.

### 5. Description détaillée de l'invention

### 5.1. Rappel du principe de l'invention

Le principe général de la technique décrite consiste à utiliser un circuit imprimé flexible pour fabriquer un corps de lecteur de carte à mémoire comprenant un logement de réception d'un connecteur de carte à mémoire surmoulé sur le circuit imprimé flexible.

Ainsi, le treillis de protection formé par la ou les pistes conductrices du circuit imprimé flexible est lui-même protégé par le surmoulage contre des conditions climatiques sources d'usure telles, que le froid ou l'humidité, ou contre des frottement d'insertion retrait de la carte à mémoire.

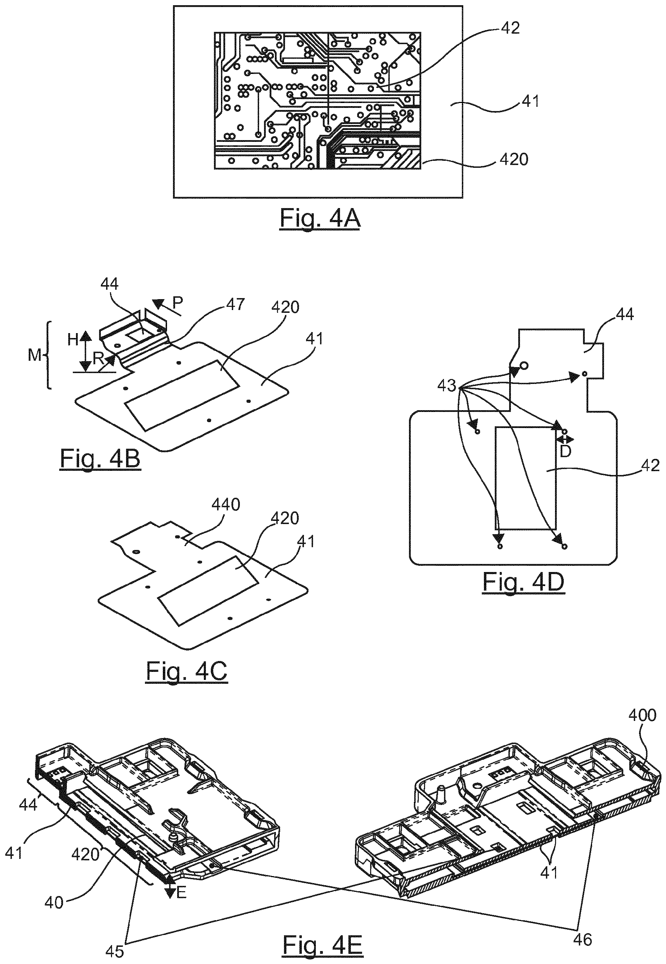

Le principe général de la technique décrite est décrit en relation avec la figure 3 illustrant le procédé de fabrication 30. Les figures 4A à 4E illustrent également les résultats des différentes étapes du procédé de fabrication selon l'invention.

Un tel procédé comprend essentiellement les deux étapes suivantes :
- obtention (31) d'un circuit imprimé flexible (41) comprenant au moins deux zones :
   - une zone (420) comprenant au moins une piste conductrice (42), également appelée treillis de protection, et
   - au moins une zone de contact (44),
- formation du logement de réception (40) d'un connecteur de carte à mémoire par surmoulage (35) du circuit imprimé flexible (41).

Plus précisément, le procédé de fabrication présenté revient à fabriquer un logement de réception d'un connecteur de carte à mémoire « enveloppant » par surmoulage un circuit imprimé flexible dont la ou les pistes conductrices constituent un treillis de protection apte à détecter une intrusion.

Ainsi, on obtient (31) tout d'abord un circuit imprimé flexible (41) tel que représenté par la figure 4A.

Ce circuit imprimé flexible (41) comprend notamment au moins une piste conductrice formant un treillis de protection permettant de détecter l'intrusion d'un instrument de détérioration.

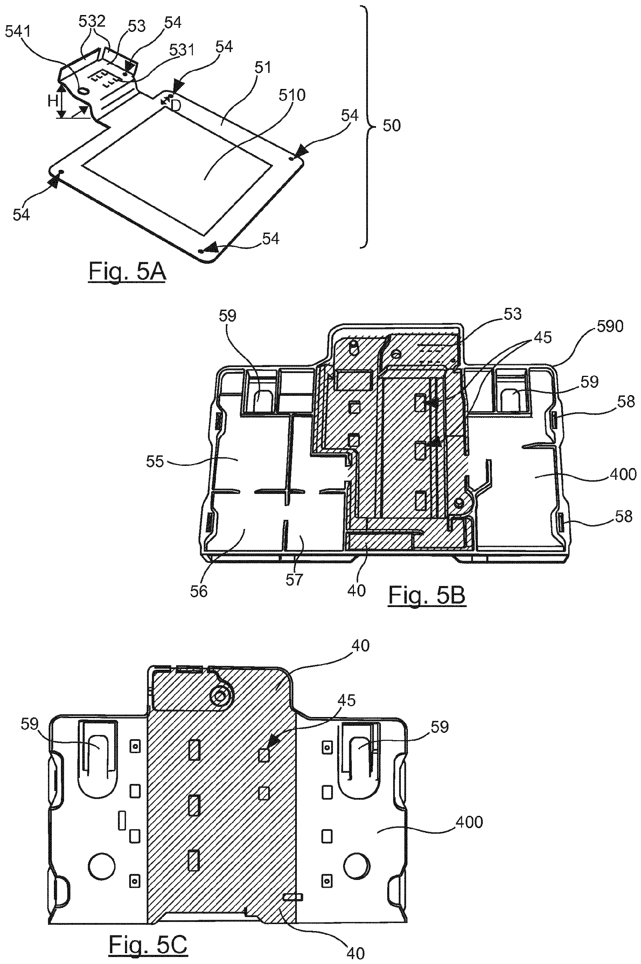

Par ailleurs, le circuit imprimé flexible comprend également une zone de contact (44) représentée sur la figure 4B. Par exemple cette zone comprend six points ou broches de connexion 531 tel que représenté par la figure 5A illustrant le circuit imprimé flexible du logement de réception du connecteur de carte à mémoire obtenu à l'issue de la mise en œuvre du procédé de fabrication selon la technique ici présentée. L'aspect structurel du corps de lecteur obtenu par le procédé de fabrication sera plus précisément décrit par la suite.

Cette zone de contact permet notamment d'éviter la problématique de la soudure du treillis de protection du circuit imprimé flexible 41 (sur la face interne du corps du connecteur de carte à mémoire) sur le circuit imprimé 61 portant des composants électroniques du lecteur de carte à mémoire (PCB pour « *Printed Circuit Board* » en anglais) tel que représenté sur la figure 6 illustrant l'assemblage d'un terminal de lecture de carte à mémoire comprenant un corps de lecteur fabriqué selon la technique décrite.

En effet, dans le corps de lecteur de carte à mémoire il y a deux circuits imprimés distincts, l'un (61) dédié aux composants électroniques assurant le fonctionnement électronique du lecteur de carte à mémoire tel que le connecteur de carte à mémoire, et l'autre (41) dédié au treillis de protection du signal I/O transitant entre la carte à mémoire (carte à puce) et le connecteur de carte à mémoire, en particulier du connecteur de carte à mémoire, permettant de détecter une intrusion.

La connexion entre ces deux éléments est réalisée par l'intermédiaire d'un connecteur élastomère, par exemple de type Zebra (Marque déposée) (63) tel que représenté sur la figure 6.

Ainsi, il n'est pas nécessaire de disposer d'un mécanisme complexe de soudure du corps de lecteur de carte à mémoire comprenant le logement de réception obtenu par surmoulage du circuit imprimé flexible portant le treillis de protection, sur le PCB comprenant les composants électroniques permettant le fonctionnement du lecteur de carte à mémoire.

En effet, comme la connexion est assurée par l'intermédiaire d'un connecteur élastomère, le montage de l'ensemble connecteur de carte à mémoire, connecteur élastomère, et logement de réception du connecteur du corps de lecteur de carte à mémoire est facilité.

Ainsi, lors de l'assemblage complet du lecteur de carte à mémoire, on obtient l'ensemble tel que représenté la figure 6.

L'avantage du circuit imprimé flexible 41 est que sa flexibilité permet une adaptation de sa forme pour épouser la forme du modèle souhaité de logement de réception d'un connecteur de carte à mémoire.

Cette forme peut directement être fixée lors de l'étape de surmoulage (35) permettant la formation du logement de réception. Dans ce cas, le circuit imprimé flexible dont on dispose a été fourni avec une taille et une forme particulière afin de pouvoir directement passer au surmoulage. Un tel circuit imprimé flexible directement utilisable pour le surmoulage est par exemple représenté par les figures 4B et 5A.

Optionnellement, il est également possible de mettre en œuvre des étapes de découpage (32), de pliage (34) et de perçage (33) entre l'étape d'obtention (31) du circuit imprimé flexible et l'étape de surmoulage.

Ces étapes optionnelles, représentées en pointillés, sur la figure 3, peuvent être effectuées l'une à la suite des autres dans un ordre quelconque.

Par exemple, au regard de la figure 3, à partir d'un circuit imprimé flexible (41) tel que représenté sur la figure 4A illustrant l'étape d'obtention (31), on procède au découpage (32) pour obtenir la forme du circuit imprimé flexible 41, tel que représenté sur la figure 4C illustrant l'étape de découpage (32), qui comprend un décrochement (440) qui sera par la suite dédié pour isoler la zone de contact (44) lors du surmoulage tel que détaillé par la suite.

Cette étape de découpage permet ainsi d'adapter la forme ou le volume du corps de lecteur de carte à mémoire fabriqué selon l'invention, cette forme pouvant varier d'un modèle de lecteur de carte à mémoire à l'autre.

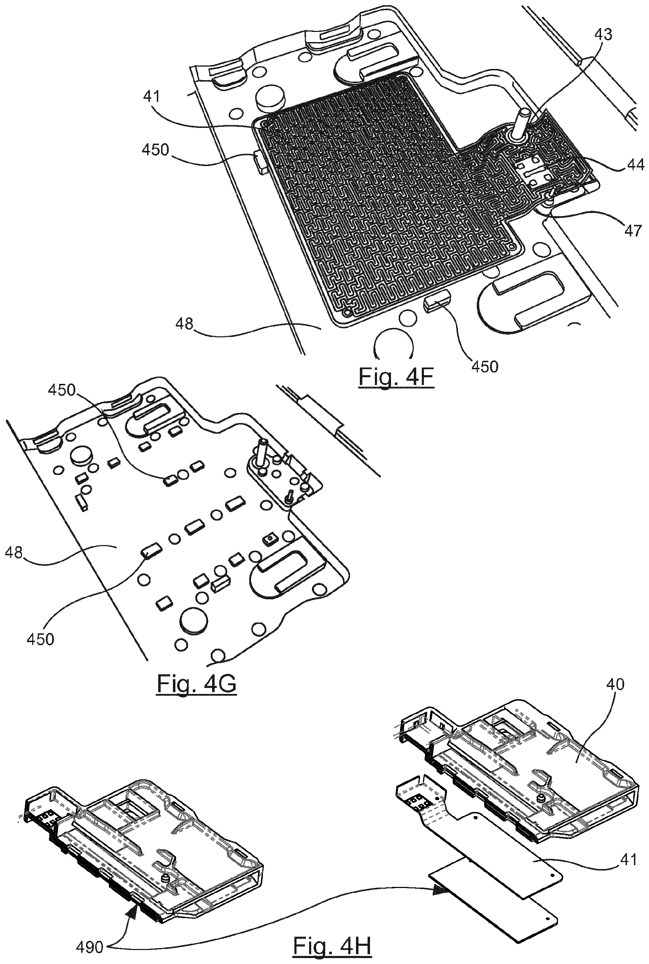

Une fois le découpage optionnel effectué, on procède au perçage (33) d'au moins une ouverture de positionnement (43) dans le circuit imprimé flexible, l'ouverture de positionnement étant prise en compte pour l'étape de formation du logement de réception par surmoulage du circuit imprimé flexible telle qu'illustrée par la figure 4F.

De telles ouvertures peuvent également être percées au préalable de sorte à améliorer la précision de pliage du circuit imprimé flexible, ou la précision de formation du logement de réception (40) par surmoulage. De telles ouvertures de positionnement (43) sont par exemple représentées sur la figure 4D et augmentent la précision du surmoulage.

Au regard de l'exemple de la figure 4D, six ouvertures de positionnement sont par exemple percées dans le circuit imprimé flexible.

Une fois le perçage (33) effectué, on procède au pliage (34) du circuit imprimé flexible tel que représenté par la figure 4B illustrant l'étape de pliage (34). Cette étape permet la « préformation » du circuit imprimé flexible afin d'obtenir plus facilement la forme souhaitée du logement de réception constituant le corps de lecteur de carte à mémoire à l'issue de l'étape de surmoulage.

Le pliage permet de définir des languettes ou des décrochés M de hauteur H (par exemple de l'ordre de 1,5mm) dans le circuit imprimé flexible afin que celui-ci adhère mieux au moule du surmoulage, mais aussi de protéger latéralement contre un accès frauduleux.

Par exemple, ces décrochés présentent en coupe, au lieu d'un angle droit, un bord arrondi de rayon R de 0,5mm à 1,5mm. Une plage de rayon de 0,5mm à 0,6mm permet notamment de limiter l'encombrement du logement de réception obtenu par surmoulage du circuit imprimé flexible ainsi plié.

Cependant, une plage de rayon de 1,2mm à 1,5mm permettra d'améliorer la répétabilité du procédé de fabrication présenté. Dans ce cas, afin de fabriquer un corps de lecteur de carte à mémoire plat voir ultra-plat la profondeur P de le décroché formée par la zone de contact du circuit imprimé flexible est allongée.

Il est à noter que le pliage est effectué sur le circuit imprimé flexible déjà formé. Ainsi, aucune piste électrique n'est détournée afin de ne pas « descendre » sur le décroché. Au contraire, selon la technique ici proposée, les pistes conductrices du circuit imprimé flexible formant le treillis « parcourent » le décroché M de hauteur H, en d'autres termes des pistes conductrices « débutent » dans la zone de contact (ou zone de connexion) 44, « descendent » le pli du décroché 47 et se poursuivent sur la zone portant le treillis de protection 420 tel que représenté sur la figure 4F.

En particulier, l'ouverture 43 située à gauche dans la zone de contact (44) présente un diamètre plus important que les cinq autres ouvertures de positionnement. Cette ouverture de positionnement 43 située à gauche dans la zone de contact (44) permet en effet, outre d'améliorer le positionnement lors du surmoulage, de permettre l'insertion d'une vis visant à solidariser le Zebra de connexion 63 précédemment mentionné et illustré par la figure 6. La vis permet en effet d'appliquer une pression permanente de solidarisation dans le temps. Un tel Zebra permet d'établir la connexion entre le circuit imprimé flexible (41) portant le treillis de protection (420) avec le connecteur de carte à mémoire (22).

À titre d'exemple, le diamètre des petites ouvertures des figures 4D ou 5A est par exemple de l'ordre 0,5mm tandis que celui de la plus grande ouverture (43, 541) de positionnement située à gauche dans la zone de contact (44, 53) permettant la solidarisation avec le Zebra au moyen d'une vis est de l'ordre de 1,5mm.

Avantageusement de telles ouvertures de positionnement sont localisées à proximité d'au moins un bord du circuit imprimé flexible et à une distance minimale (D) de 10 mm de la ou les pistes conductrices formant le treillis de protection 42.

La figure 5A représente un mode de réalisation, différent de celui représenté par la figure 4D, dans lequel les quatre ouvertures de positionnement (54) situées sur la partie (51) du circuit imprimé flexible portant le treillis de protection (510) sont localisée à proximité des coins de cette partie et à une distance D du treillis de protection (510) supérieure à 10mm.

Il est à noter que le même résultat de fabrication pourrait être obtenu si l'étape de perçage est effectuée en premier avant l'étape de pliage suivie de celle de découpage, ou si l'étape de pliage est effectuée en premier.

L'ordre des étapes optionnelles de découpage, pliage et perçage relève donc du choix du fabricant. De plus, il est également possible de n'appliquer que l'étape de découpage et non les étapes optionnelles de pliage et de perçage, ou deux parmi trois de ces étapes optionnelles.

Directement après l'étape d'obtention du circuit imprimé flexible, ou après l'une ou l'ensemble des étapes optionnelles de perçage (33), pliage (34) et découpage (32) précitée, le procédé selon la présente technique met en œuvre la formation du logement de réception (40) d'un connecteur de carte à mémoire par surmoulage (35) du circuit imprimé flexible (41).

La technique de surmoulage est classique, et consiste à former (34) à chaud le circuit imprimé flexible, puis à l'insérer dans un moule (dont une partie 48 est représentée sur la figure 4G) correspondant au modèle de logement de réception de connecteur de carte à mémoire souhaité et enfin à surmouler le logement de réception par injection de matière dans le moule 48.

Les ouvertures de positionnement (43) précédemment citées permettent par exemple de tendre le circuit imprimé flexible dans le moule, puis celui-ci est fixé dans le moule au moyen de pions inséré dans les ouvertures de positionnement et le surmoulage est effectué.

Par ailleurs, le matériau de surmoulage est par exemple un matériau classique à base de polycarbonate.

Selon un mode de réalisation particulier, ce matériau est conducteur, par exemple un polycarbonate conducteur. Cette caractéristique du matériau de surmoulage permet avantageusement de dissiper les charges électrostatiques lors de l'introduction de la carte à mémoire dans le corps de lecteur de carte à mémoire.

On obtient à l'issu de l'étape de surmoulage le corps de lecteur de carte à mémoire tel que représenté selon la coupe de la figure 4E.

Au regard de la figure 4E, il peut être noté que la zone (420) comprenant la piste conductrice est recouverte par un matériau de surmoulage sur ses deux faces, l'épaisseur du matériau de surmoulage étant par exemple de l'ordre de 0,6mm de chaque côté du circuit imprimé flexible. On obtient donc pour cette zone une épaisseur totale E de l'ordre de 1,5mm, l'épaisseur du circuit imprimé flexible étant de l'ordre 0,2mm. La zone de contact (44) est quant à elle recouverte par un matériau de surmoulage sur une seule face.

En particulier, lors de l'étape de surmoulage, des pions de maintien 450 du moule illustré par la figure 4G permettent de maintenir par pincement le circuit imprimé flexible 41 en position optimale. Ces pions 450 sont des protubérances sortant naturellement (en d'autres termes selon la direction principale d'ouverture du moule) du moule de surmoulage que ce soit pour la partie fixe et la partie mobile du pion qui assure le pincement du circuit imprimé flexible. En outre, la position optimale du circuit imprimé flexible 41 lors du surmoulage est également assurée par des glissières de maintien 46, sortant avec tiroir (en d'autres termes démoulé selon une direction différente de la direction principale d'ouverture du moule, par exemple perpendiculairement) mobiles par glissement telles des tiroirs.

Des ouvertures 45 correspondant aux pions de maintien 450 sont donc obtenues dans le logement de réception délivré par l'étape de formation par surmoulage tel qu'illustré par la figure 4E. Cependant, ces ouvertures 45 ne sont pas dommageables au regard de la sécurisation du treillis car elles sont situées sur une zone centrale du logement de réception que l'on ne peut atteindre à travers la fente du lecteur. Il est donc impossible d'accéder par ces ouvertures à des signaux sensibles à protéger.

Selon une variante de réalisation, il est également proposé d'ajouter, par exemple au moyen d'une solidarisation par collage sous le circuit imprimé flexible afin d'être en contact avec la face arrière du logement de réception représentée sur la figure 5C, une plaque rigide 490, par exemple en métal, assurant une rigidité de l'ensemble tel que représenté sur la figure 4H pour fiabiliser le processus d'injection, et éviter des déformations excessives du circuit imprimé flexible durant l'injection.

En particulier, la figure 4H illustre que le surmoulage « enveloppe » la superposition constituée du circuit imprimé flexible et d'une plaque rigide, par exemple métallique, solidarisée à la face arrière du circuit imprimé flexible.

Ainsi, la plaque rigide permet de limiter la déformation du circuit imprimé flexible lors de l'injection et l'utilisation de pressions d'injections plus élevées. En conséquence, des épaisseurs de surmoulage plus faibles et néanmoins répétables (pouvant descendre à environ 0.4mm) sont obtenues.

En outre, l'utilisation d'un telle plaque rigide (490), par exemple en métal renforce la sécurité, car il devient extrêmement difficile d'accéder aux signaux du treillis de protection localisé sous cette plaque de métal (490) même par les ouvertures 45 précédemment mentionnées.

### 5.2. Description d'un exemple de corps de lecteur de carte à mémoire et d'un terminal obtenus par le procédé de fabrication selon la technique décrite.

On présente en relation avec les figures 5A à 5C différentes parties du corps de lecteur de carte à mémoire selon la technique décrite.

Par ailleurs, la figure 6 illustre l'assemblage d'un terminal de lecture de carte à mémoire comprenant un corps de lecteur fabriqué selon la technique décrite.

Ainsi, la figure 5A illustre le circuit imprimé flexible 50 à partir duquel le logement de réception du connecteur de carte à mémoire sera formé par surmoulage.

Un tel circuit imprimé flexible 50 se présente par exemple sous la forme d'une première zone plane 51 comprenant le treillis de protection 510 constituées de pistes conductrices non représentées, et une deuxième zone appelée zone de contact 53 surélevée au regard de la zone plane 51 comprenant le treillis de protection 510. La surélévation de la zone de contact 53 au regard de la zone plane 51 correspond à un décroché de hauteur H et de rayon R.

Un tel relief du circuit imprimé flexible est apte à « épouser » la forme du logement de réception souhaitée du corps de lecteur de carte à mémoire.

La zone de contact 53 comprend six points ou broches de connexion 531 et deux ouvertures de positionnement 54 et 541, permettant d'améliorer le positionnement du circuit imprimé flexible dans le moule utilisé pour le surmoulage permettant de former le logement de réception (40) du connecteur de carte à mémoire, ce logement de réception étant une partie du corps de lecteur de carte.

L'ouverture de positionnement 541 présente un diamètre supérieur à celui de l'ouverture de positionnement 54 située dans la zone de contact 53 afin de permettre également le passage d'une vis permettant la solidarisation d'un connecteur élastomère, par exemple de type Zebra (Marque déposée).

Sur la zone plane 51 comprenant le treillis de protection 510, les ouvertures de positionnement 54 sont localisées à proximité du bord du circuit imprimé flexible et à une distance D d'au moins 10mm d'une piste conductrice du treillis de protection 510.

Les figures 5B et 5C présentent une partie des côtés internes et externes de la face postérieure (400) du corps de lecteur de carte à mémoire fabriquée selon la technique décrite.

Le logement de réception du connecteur de carte à mémoire (40) est représenté en hachuré et correspond à une partie du corps de lecteur de carte à mémoire.

Ce logement de réception (40) est obtenu par surmoulage du circuit imprimé flexible (50) représenté sur la figure 5A. Ainsi la zone plane (51) comprenant le treillis de protection est « enveloppée » par le matériau de surmoulage formant le logement de réception (40).

Au regard du côté externe de la partie de la face postérieure (400) de corps de lecteur de carte mémoire représenté sur la figure 5C, il peut être constaté que le matériau de surmoulage recouvre les deux faces de la zone plane (51) du circuit imprimé flexible.

Au contraire, la zone de contact est bien recouverte, et par la même protégée, sur la face externe du corps de lecteur de carte à mémoire, mais découverte sur la face interne afin d'établir le contact avec le connecteur de carte à mémoire que le logement de réception (40) est apte à recevoir.

On peut également noter que la face postérieure du corps de lecteur de carte à mémoire selon la technique décrite comprend différents compartiments 55, 56 et 57 apte à recevoir différents composants.

En outre, le corps de lecteur de carte à mémoire comprend également des ouvertures 58 permettant l'insertion de pions métalliques d'ancrage (non représentés), fixant, dans le corps de lecteur de carte à mémoire, le PCB (61) dédié aux composants électroniques assurant le fonctionnement électronique du lecteur de carte à mémoire tel que le connecteur de carte à mémoire, et soudés avec de la pâte à braser. De tels pions métalliques d'ancrage maintiennent le connecteur lors des insertions répétées d'une carte à mémoire dans le lecteur de carte à mémoire. Ces pions métalliques d'ancrage peuvent également présenter une forme particulière, adaptée d'une part pour remplir une fonction de guidage de la carte à mémoire dans le lecteur et d'autre part pour réaliser, si besoin, une décharge électrostatique des arêtes de la carte insérée.

Par ailleurs, le corps de lecteur de carte à mémoire comprend également des languettes 59 en matériau de surmoulage, par exemple un polycarbonate conducteur. Ces languettes permettent également, selon une variante de réalisation, une décharge électrostatique de la carte à mémoire lorsqu'elle est insérée complètement dans le lecteur de carte de sorte à venir en contact avec le bord supérieur 590 du corps de lecteur de carte à mémoire.

On présente en relation avec la figure 6, l'assemblage d'un terminal de lecture de carte à mémoire comprenant un corps de lecteur fabriqué selon la technique décrite.

Cet assemblage revient notamment à superposer :
- un premier circuit imprimé 61 dédié aux composants électroniques assurant le fonctionnement électronique du lecteur de carte à mémoire tel que le connecteur de carte à mémoire,
- un connecteur de carte à mémoire 62 comprenant notamment des lames ressort métalliques, sur une (621) desquelles transitent le signal I/O transitant entre la carte à mémoire (carte à puce) et le connecteur de carte à mémoire,
- un Zebra 63 permettant d'établir la connexion entre le circuit imprimé flexible comprenant au moins une zone de contact 53 découverte sur le côté intérieur et une zone plane portant le treillis de protection 51 surmoulée sur ses deux faces par le matériau de surmoulage formant le logement de réception 40, et le connecteur de carte à mémoire 62,
- le côté externe de la face postérieure 64 du corps de lecteur de carte à mémoire, tel qu'également représenté sur la figure 5C, comprenant le logement de réception 40 surmoulé sur le circuit imprimé flexible comprenant au moins une zone de contact 53 découverte sur le côté intérieur et une zone plane portant le treillis de protection 51.

## Revendications

1. Procédé de fabrication (30) d'un corps de lecteur de carte à mémoire de forme globalement parallélépipédique rectangle comprenant une fente d'insertion d'une carte à mémoire, dont une face postérieure (400) comprend un logement de réception (40) d'un connecteur de carte à mémoire (62), ledit logement de réception (40) étant d'une forme volumique prédéterminée,
**caractérisé en ce que** ledit procédé de fabrication (30) comprend les étapes successives suivantes:
- obtention (31) d'un circuit imprimé flexible (41) comprenant au moins deux zones :
- une zone (420) comprenant au moins une piste conductrice (42) formant un treillis de protection apte à détecter une intrusion, et
- au moins une zone de contact (44),
- formation dudit logement de réception (40) par surmoulage (35) dudit circuit imprimé flexible (41).

2. Procédé de fabrication selon la revendication 1, **caractérisé en ce qu'**il comprend une étape de découpage (32) dudit circuit imprimé flexible.

3. Procédé de fabrication selon les revendications 1 ou 2, **caractérisé en ce que** ladite étape de formation dudit logement de réception (40) par surmoulage (35) dudit circuit imprimé flexible (41) comprend une étape de solidarisation d'une plaque rigide (490) sous ledit circuit imprimé flexible, ladite étape de solidarisation étant mise en œuvre préalablement audit surmoulage.

4. Procédé de fabrication selon l'une des revendications précédentes, **caractérisé en ce qu'**il comprend une étape de une étape de perçage (33) d'au moins une ouverture de positionnement (43) dans ledit circuit imprimé flexible, ladite ouverture de positionnement étant prise en compte pour ladite étape de formation dudit logement de réception (220) par surmoulage dudit circuit imprimé flexible et/ou une étape de pliage (34) dudit circuit imprimé flexible.

5. Procédé de fabrication selon la revendication 4, **caractérisé en ce que** ladite au moins une ouverture de positionnement (43) est localisée à proximité d'au moins un bord dudit circuit imprimé flexible (41) et à une distance minimale de 10 mm de ladite au moins une piste conductrice (42).

6. Procédé de fabrication selon l'une des revendications précédentes, **caractérisé en ce que** ledit surmoulage est tel que :
- ladite zone (51) comprenant ladite au moins une piste conductrice est recouverte par un matériau de surmoulage sur ses deux faces,
- ladite zone de contact (53) est recouverte par un matériau de surmoulage sur une seule face.

7. Procédé de fabrication selon l'une des revendications précédentes, **caractérisé en ce que** ledit matériau de surmoulage est un matériau conducteur ou dissipatif.

8. Corps de lecteur de carte à mémoire de forme globalement parallélépipédique rectangle comprenant une fente d'insertion d'une carte à mémoire, dont une face postérieure (400) comprend un logement de réception (40) d'un connecteur de carte à mémoire (22), ledit logement de réception (40) étant d'une forme volumique prédéterminée,
**caractérisé en ce que** ledit logement de réception (40) est un surmoulage d'un circuit imprimé flexible (41) comprenant au moins deux zones :
- une zone (420) comprenant au moins une piste conductrice (42) formant un treillis de protection apte à détecter une intrusion, et
- au moins une zone de contact (44).

9. Corps de lecteur de carte à mémoire selon la revendication 8, **caractérisé en ce qu'**il comprend au moins une ouverture de positionnement (43) dans ledit circuit imprimé flexible.

10. Terminal de lecture de carte à mémoire **caractérisé en ce qu'**il comprend un corps de lecteur de carte selon l'une des revendications 8 et 9.

## Patentansprüche

1. Verfahren zur Herstellung (30) eines Speicherkartenleserkörpers von allgemein rechteckiger parallelepipedischer Form, umfassend einen Schlitz zum Einstecken einer Speicherkarte, wovon eine Rückseite (400) eine Unterbringung zur Aufnahme (40) eines Speicherkartenanschlusses (62) aufweist, wobei die Unterbringung zur Aufnahme (40) von einer vorherbestimmten Volumenform ist,
**dadurch gekennzeichnet, dass** das Verfahren zur Herstellung (30) die folgenden Schritte aufweist:
- Erhalten (31) einer flexiblen gedruckten Schaltung (41), umfassend mindestens zwei Bereiche:
- einen Bereich (420), der mindestens eine Leiterbahn (42) aufweist, die ein Schutzgitter bildet, das geeignet ist, ein Eindringen zu erkennen, und
- mindestens einen Kontaktbereich (44),
- Bilden der Unterbringung zur Aufnahme (40) durch Überformen (35) der flexiblen gedruckten Schaltung (41).

2. Verfahren zur Herstellung nach Anspruch 1, **dadurch gekennzeichnet, dass** es einen Schritt des Schneidens (32) der flexiblen gedruckten Schaltung aufweist.

3. Verfahren zur Herstellung nach Anspruch 1 oder 2, **dadurch gekennzeichnet, dass** der Schritt des Bildens der Unterbringung zur Aufnahme (40) durch Überformen (35) der flexiblen gedruckten Schaltung (41) einen Schritt des Befestigens einer starren Platte (490) unter der flexiblen gedruckten Schaltung aufweist, wobei der Schritt des Befestigens vor dem Überformen durchgeführt wird.

4. Verfahren zur Herstellung nach einem der vorhergehenden Ansprüche, **dadurch gekennzeichnet, dass** es einen Schritt des Bohrens (33) von mindestens einer Positionierungsöffnung (43) in der flexiblen gedruckten Schaltung aufweist, wobei die Positionierungsöffnung für den Schritt des Bildens der Unterbringung zur Aufnahme (220) durch Überformen der flexiblen gedruckten Schaltung und/oder einen Schritt des Faltens (34) der flexiblen gedruckten Schaltung berücksichtigt wird.

5. Verfahren zur Herstellung nach Anspruch 4, **dadurch gekennzeichnet, dass** die mindestens eine Positionierungsöffnung (43) in der Nähe von mindestens einem Rand der flexiblen gedruckten Schaltung (41) und in einem Mindestabstand von 10 mm von der mindestens einen Leiterbahn (42) lokalisiert ist.

6. Verfahren zur Herstellung nach einem der vorhergehenden Ansprüche, **dadurch gekennzeichnet, dass** das Überformen derart ist, dass:
- der Bereich (51), der die mindestens eine Leiterbahn aufweist, auf seinen zwei Seiten mit einem Überformungsmaterial bedeckt ist,
- der Kontaktbereich (53) auf einer einzigen Seiten mit einem Überformungsmaterial bedeckt ist.

7. Verfahren zur Herstellung nach einem der vorhergehenden Ansprüche, **dadurch gekennzeichnet, dass** das Überformungsmaterial ein leitfähiges oder dissipatives Material ist.

8. Speicherkartenleserkörper von allgemein rechteckiger parallelepipedischer Form, umfassend einen Schlitz zum Einstecken einer Speicherkarte, wovon eine Rückseite (400) eine Unterbringung zur Aufnahme (40) eines Speicherkartenanschlusses (22) aufweist, wobei die Unterbringung zur Aufnahme (40) von einer vorherbestimmten Volumenform ist,
**dadurch gekennzeichnet, dass** die Unterbringung zur Aufnahme (40) eine Überformung einer flexiblen gedruckten Schaltung (41) ist, die mindestens zwei Bereiche aufweist:
- einen Bereich (420), der mindestens eine Leiterbahn (42) aufweist, die ein Schutzgitter bildet, das geeignet ist, ein Eindringen zu erkennen, und
- mindestens einen Kontaktbereich (44).

9. Speicherkartenleserkörper nach Anspruch 8, **dadurch gekennzeichnet, dass** er mindestens eine Positionierungsöffnung (43) in der flexiblen gedruckten Schaltung aufweist.

10. Speicherkartenleseterminal, **dadurch gekennzeichnet, dass** es einen Speicherkartenleserkörper nach einem der Ansprüche 8 und 9 aufweist.

## Claims

1. Method for manufacturing (30) a memory card reader body with a generally rectangular parallelepiped shape comprising a slot for inserting a memory card, one rear face (400) of which comprises a reception housing (40) for a memory card connector (62), said reception housing (40) being of predetermined volume shape, **characterized in that** said method for manufacturing (30) comprises the following successive steps:
- obtaining (31) a flexible printed circuit board (41) comprising at least two zones:
- a zone (420) comprising said at least one conductive track (42) forming a protection lattice capable of detecting an intrusion, and
- at least one contact zone (44),
- forming said reception housing (40) by overmolding (35) of said flexible printed circuit board (41).

2. Method for manufacturing according to claim 1, **characterized in that** it comprises a step (32) for cutting out said flexible printed circuit board.

3. Method for manufacturing according to claims 1 or 2, **characterized in** said step for shaping said reception housing (40) by overmolding (35) of said flexible printed circuit board (41) comprises a step of fixedly attaching a rigid plate (490) beneath said flexible printed circuit board, said step for fixedly attaching being implemented prior to said overmolding.

4. Method for manufacturing according to one of the preceding claims, **characterized in that** it comprises a step for drilling (33) at least one positioning aperture (43) in the flexible printed circuit board, said positioning aperture being taken into account for said step for shaping said reception housing (220) by overmolding of said flexible printed circuit board and/or a step for folding (34) said flexible printed circuit board.

5. Method for manufacturing according to claim 4, **characterized in that** said at least one positioning aperture (43) is located in proximity to at least one edge of said flexible printed circuit board (41) and at a minimum distance of 10mm from said at least one conductive track (42).

6. Method for manufacturing according to one of the preceding claims, **characterized in that** said overmolding is such that:
- said zone (51) comprising at least one conductive track is covered with an overmolding material on both its faces,
- said contact zone (53) is covered with an overmolding material on only one face.

7. Method for manufacturing according to one of the preceding claims, **characterized in that** said overmolding material is a conductive or dissipative material.

8. Memory card reader body of a generally rectangular parallelepiped shape comprising a slot for inserting a memory card, a rear face (400) of which comprises a reception housing (40) for a memory card connector (22), said reception housing (40) having a predetermined volume shape,
**characterized in that** said reception housing (40) is an overmolding of flexible printed circuit board (41) comprising at least two zones:
- a zone (420) comprising said at least one conductive track (42) forming a protection lattice capable of detecting an intrusion, and
- at least one contact zone (44).

9. Memory card reader body according to claim 8, **characterized in that** it comprises at least one positioning aperture (43) in said flexible printed circuit board.

10. Memory card reading terminal comprising a card reader body according to one of the claims 8 and 9.
